(19) Europäisches Patentamt
European Patent Office
Office européen des brevets

(11) EP 4 693 377 A1

(12) # EUROPEAN PATENT APPLICATION
published in accordance with Art. 153(4) EPC

(43) Date of publication:
**11.02.2026 Bulletin 2026/07**

(21) Application number: **25792574.3**

(22) Date of filing: **23.05.2025**

(51) International Patent Classification (IPC):
***H01L 21/3065*** *(2006.01)*

(52) Cooperative Patent Classification (CPC):
**H01L 21/3065**

(86) International application number:
**PCT/JP2025/018801**

(87) International publication number:
**WO 2025/253951 (11.12.2025 Gazette 2025/50)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **06.06.2024 JP 2024092419**

(71) Applicant: **DAIKIN INDUSTRIES, LTD.**
**Osaka-Shi, Osaka 530-0001 (JP)**

(72) Inventors:
- **ETO, Yusuke**
**Osaka-shi, Osaka 530-0001 (JP)**
- **SUGIYAMA, Akinari**
**Osaka-shi, Osaka 530-0001 (JP)**
- **KUROKI, Yoshichika**
**Osaka-shi, Osaka 530-0001 (JP)**
- **NAKAMURA, Shingo**
**Osaka-shi, Osaka 530-0001 (JP)**

(74) Representative: **Hoffmann Eitle**
**Patent- und Rechtsanwälte PartmbB**
**Arabellastraße 30**
**81925 München (DE)**

(54) **ETCHING METHOD USING HEXAFLUOROPROPENE**

(57) The present disclosure aims to provide a novel etching method using hexafluoropropene. An etching method using hexafluoropropene is provided.

EP 4 693 377 A1

## Description

Technical Field

The present disclosure relates to an etching method using hexafluoropropene.

Background Art

PLT 1 discloses a method of etching a silicon-based material such as a silicon oxide film and/or a low-dielectric constant film containing silicon by using hexafluoropropene.

Citation List

Patent Literature

PTL 1: WO0221586-A1

Summary of Invention

Technical Problem

The present disclosure aims to provide a novel etching method using hexafluoropropene.

Solution to Problem

The present disclosure encompasses the following features.

Item 1.

An etching gas comprising:

(1) hexafluoropropene; and
(2) at least one component selected from the group consisting of hexafluorocyclopropane, pentafluoropropene, and a hexafluoropropene-derived dimer and/or trimer.

Item 2.

The etching gas according to Item 1,
wherein, based on the total amount of the etching gas,

the hexafluoropropene (1) is present at 95 vol% to 99.99999 vol%, and
the at least one component selected from the group consisting of hexafluorocyclopropane, pentafluoropropene, and a hexafluoropropene-derived dimer and/or trimer (2) is present at 1 ppm by volume to 1,000 ppm by volume.

Item 3.

An etching method comprising etching a silicon oxide film or a silicon-based material having a silicon nitride film formed thereon using a gas plasma of the etching gas according to Item 1.

Item 4.

The etching method according to Item 3,
wherein the silicon-based material is etched by continuously supplying the etching gas and (3) an inert gas separately and generating an etching gas mixture in a chamber.

Item 5.

The etching method according to Item 3,

wherein the silicon-based material is etched by continuously supplying the etching gas and (4) an oxidizing gas and/or a reducing gas separately and generating an etching gas mixture in a chamber.

Item 6.

The etching method according to Item 3,
wherein the silicon-based material is etched by continuously supplying the etching gas, (3) an inert gas, and (4) an oxidizing gas and/or a reducing gas separately and generating an etching gas mixture in a chamber.

Item 7.

The etching method according to any one of Items 3 to 6,
wherein the silicon-based material is a semiconductor manufacturing substrate.

The etching gas of the present disclosure contains (1) hexafluoropropene and (2) at least one component selected from the group consisting of hexafluorocyclopropane, pentafluoropropene, and a hexafluoropropene-derived dimer and/or trimer. Use of the etching gas of the present disclosure for hole etching in a silicon oxide film ($SiO_2$ film) or a silicon-based material including a silicon nitride film (SiN film) can reduce lateral etching and achieve etching in which the processed hole shape is well maintained.

Advantageous Effects of Invention

The present disclosure can provide a novel etching method using hexafluoropropene.

Description of Embodiments

In the present specification, the terms "include," "contain," and variations thereof express concepts that encompass all of "comprise," "consist essentially of," and "consist of." In the present specification, when a numerical range is expressed as "A to B," the expression means A or more and B or less. In the present specification, when expressions such as "part(s)" and "%" are used, these mean parts by mass, parts by weight, mass%, or wt%.

<u>[1] Etching gas</u>

In conventional semiconductor production, etching of holes is performed using hexafluoropropene as an etching gas.

However, study is required because when only hexafluoropropene is used as an etching gas for hole etching, lateral etching occurs, failing to well maintain the processed hole shape. A currently available process uses hexafluoro-1,3-butadiene ($C_4F_6$) or the like to maintain the processed hole shape. However, hexafluoro-1,3-butadiene is an expensive gas, and the hole etching cost is high in such a process.

The present disclosure encompasses an etching gas containing hexafluoropropene to be used for etching a semiconductor manufacturing substrate in semiconductor production.

The etching gas of the present disclosure contains (1) hexafluoropropene as a first component and (2) at least one component selected from the group consisting of hexafluorocyclopropane, pentafluoropropene, and a hexafluoropropene-derived dimer and/or trimer as a second component.

When etching is performed using the etching gas of the present disclosure, the etching gas may contain an inert gas.

When etching is performed using the etching gas of the present disclosure, the etching gas may contain an oxidizing gas and/or a reducing gas.

The etching gas of the present disclosure contains (1) hexafluoropropene as a first component and (2) at least one component selected from the group consisting of hexafluorocyclopropane, pentafluoropropene, and a hexafluoropropene-derived dimer and/or trimer as a second component. Use of the etching gas of the present disclosure for hole etching in a silicon oxide film ($SiO_2$ film) or a silicon-based material including a silicon nitride film (SiN film) can achieve etching in which the processed hole shape is well maintained.

The etching gas of the present disclosure, which contains a second component, can reduce lateral etching by about 10% to 30% at low cost in hole etching in a semiconductor manufacturing substrate.

<u>(1) Hexafluoropropene</u>

The etching gas of the present disclosure contains (1) hexafluoropropene ($CF_3$-$CF$=$CF_2$, also known as

hexafluoropropylene, HFP) as a first component.

The etching gas of the present disclosure contains the first component "(1) hexafluoropropene" as a main component.

In order to reduce lateral etching and achieve etching in which the processed hole shape is well maintained when the etching gas of the present disclosure is used for hole etching, the amount of hexafluoropropene in the etching gas of the present disclosure based on the total amount (gas volume) of the etching gas of the present disclosure is preferably 95 vol% to 99.99999 vol%, more preferably 96 vol% to 99.999 vol%, even more preferably 97 vol% to 99.995 vol%, and particularly preferably 98 vol% to 99.99 vol%.

(2) At least one component selected from the group consisting of hexafluorocyclopropane, pentafluoropropene, and a hexafluoropropene-derived dimer and/or trimer

The etching gas of the present disclosure contains, as a second component, (2) at least one component selected from the group consisting of hexafluorocyclopropane, pentafluoropropene, and a hexafluoropropene-derived dimer and/or trimer.

(2-1) Hexafluorocyclopropane

The etching gas of the present disclosure contains hexafluorocyclopropane (c-$C_3F_6$) as a second component. Thus, the use of the etching gas of the present disclosure for hole etching can reduce lateral etching and achieve etching in which the processed hole shape is well maintained.

In order to reduce lateral etching, achieve etching in which the processed hole shape is well maintained, prevent or reduce clogging of holes (clogging) in the processed shape, and enable efficient etching when the etching gas of the present disclosure is used for hole etching, the amount of hexafluorocyclopropane in the etching gas of the present disclosure based on the total amount (gas volume) of the etching gas of the present disclosure is preferably 0.1 ppm by volume (ppm volume) to 1,000 ppm by volume (ppm volume), more preferably 1 ppm by volume to 500 ppm by volume, even more preferably 2.5 ppm by volume to 250 ppm by volume, and particularly preferably 5 ppm by volume to 100 ppm by volume.

(2-2) Pentafluoropropene

The etching gas of the present disclosure contains pentafluoropropene ($C_3HF_5$) as a second component. Thus, the use of the etching gas of the present disclosure for hole etching can reduce lateral etching and achieve etching in which the processed hole shape is well maintained.

There is no limitation on pentafluoropropene as the second component, and either isomer can be used. Use of 1,1,2,3,3-pentafluoropropene ($F_2C=CF-CHF_2$), 1,1,3,3,3-pentafluoropropene ($F_2C=CH-CF_3$), (E/Z)-1,2,3,3,3-pentafluoro-1-propene ($HFC=CF-CF_3$), or the like is preferred.

In the etching gas of the present disclosure, one pentafluoropropene (including isomers) may be used alone or two or more thereof may be used (blended) as a mixture.

In order to reduce lateral etching, achieve etching in which the processed hole shape is well maintained, and prevent or reduce clogging of holes (clogging) in the processed shape when the etching gas of the present disclosure is used for hole etching, the amount of pentafluoropropene in the etching gas of the present disclosure based on the total amount (gas volume) of the etching gas of the present disclosure is preferably 1 ppm by volume (ppm volume) to 1,000 ppm by volume (ppm volume), more preferably 5 ppm by volume to 500 ppm by volume, even more preferably 10 ppm by volume to 100 ppm by volume, and particularly preferably 20 ppm by volume to 50 ppm by volume.

(2-3) Hexafluoropropene-derived dimer and/or trimer

The etching gas of the present disclosure contains a hexafluoropropene-derived dimer and/or trimer as a second component. Thus, the use of the etching gas of the present disclosure for hole etching can reduce lateral etching and achieve etching in which the processed hole shape is well maintained.

In the etching gas of the present disclosure, the second component "hexafluoropropene-derived dimer and/or trimer" is a product prepared from hexafluoropropene ($C_3F_6$) and is a component different from the first component "(1) hexafluoropropene (HFP)."

(a) Method for preparing hexafluoropropene-derived dimer

The hexafluoropropene-derived dimer includes the cis-isomer and the trans-isomer shown below. In the etching

gas of the present disclosure, either isomer may be used irrespective of its abundance ratio.

The compounds represented by Formula (I) includes the cis-isomer and the trans-isomer, unless otherwise specified.

Formula (I)

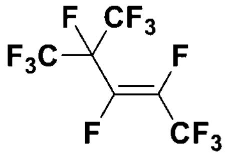

(E) ,

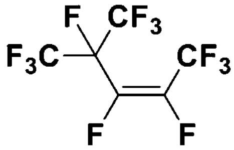

(Z) ,

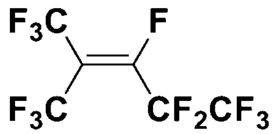

The hexafluoropropene dimer may include (E)-1,1,1,2,3,4,5,5,5-nonafluoro-4- (trifluoromethyl)-2-pentene, (Z)-1,1,1,2,3,4,5,5,5-nonafluoro-4-(trifluoromethyl)-2-pentene, and/or 1,1,1,3,4,4,5,5,5-nonafluoro-2-(trifluoromethyl)-2-pentene.

The hexafluoropropene-derived dimer is prepared by the method described in JPH06-234672A, for example.

In the total amount of hexafluoropropene (HFP)-derived dimers (the sum amount of compounds represented by Formulas (I), (II), and (III) (a HFP dimer mixture), below described as "the total amount of HFP dimers"), the mixing ratio of the compound represented by Formula (I) based on the total amount of HFP dimers is preferably in the following order: 1 mass% or more, 10 mass% or more, 30 mass% or more, 40 mass% or more, and 45 mass% or more. A particularly preferred mixing ratio is 50 mass% or more. The mixing ratio of the compound represented by Formula (I) based on the total amount of HFP dimers may be 85 mass% or more. When the mixing ratio of the compound represented by Formula (I) is high in the total amount of HFP dimers, the HFP dimer mixture has a lower viscosity.

The mixing ratio of the compound represented by Formula (I) based on the total amount of HFP dimers is preferably in the following order: 99 mass% or less, 90 mass% or less, 85 mass% or less (or less than 85 mass%), 80 mass% or less, and 70 mass% or less. A particularly preferred mixing ratio is 60 mass% or less.

The mixing ratio of the compound represented by Formula (I) based on the total amount of HFP dimers is adjusted to, for example, 10 mass% or more and 90 mass% or less, 10 mass% or more and 85 mass% or less, 10 mass% or more and less than 85 mass%, 20 mass% or more and less than 85 mass%, 30 mass% or more and 90 mass% or less, 30 mass% or more and less than 85 mass%, 35 mass% or more and 85 mass% or less, 35 mass% or more and 60 mass% or less, 40 mass% or more and less than 85 mass%, 40 mass% or more and 80 mass% or less, 50 mass% or more and less than 85 mass%, 50 mass% or more and 60 mass% or less, 55 mass% or more and 80 mass% or less, 60 mass% or more and 75 mass% or less, or 65 mass% or more and 70 mass% or less.

The mixing ratio of the compound represented by Formula (I) based on the total amount of HFP dimers is preferably in the following order: 30 mass% or more and 90 mass% or less, 40 mass% or more and less than 85 mass%, 40 mass% or more and 80 mass% or less, and 45 mass% or more and 70 mass% or less. A particularly preferred mixing ratio is 50 mass% or more and 60 mass% or less.

(b) Method for preparing a hexafluoropropene-derived trimer

The hexafluoropropene-derived trimer includes the isomers shown below. In the etching gas of the present disclosure, either isomer may be used irrespective of its abundance ratio.

The compound represented by Formula (I) includes E-diastereomer (I-(E)) and Z-diastereomer (I-(Z)), unless otherwise specified.

( I-(Z) )

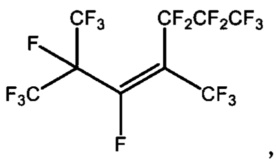

,

( I-(E) )

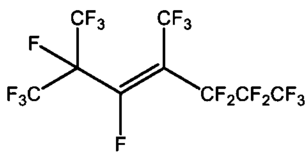

,

( II )

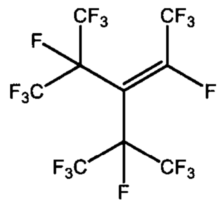

,

( III )

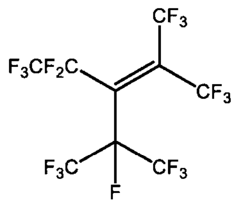

The hexafluoropropene-derived trimer is appropriately selected depending on the desired abundance ratio and is produced by, for example, the method described in Chem Bar (1973), Vol. 106, pp. 2950-2959.

In the total amount of hexafluoropropene (HFP)-derived trimers (the sum amount of compounds represented by Formulas (I), (II), and (III) (an HFP trimer mixture), below described as "the total amount of HFP trimers"), the mixing ratio of the compound represented by Formula (I) based on the total amount of HFP trimers is preferably in the following order: 1 mass% or more, 10 mass% or more, 30 mass% or more, 40 mass% or more, and 45 mass% or more. A particularly preferred mixing ratio is 50 mass% or more. The mixing ratio of the compound represented by Formula (I) based on the total amount of HFP trimers may be 85 mass% or more. When the mixing ratio of the compound represented by Formula (I) is high in the total amount of HFP trimers, the HFP trimer mixture has a lower viscosity.

The mixing ratio of the compound represented by Formula (I) based on the total amount of HFP trimers is preferably in the following order: 99 mass% or less, 90 mass% or less, 85 mass% or less (or less than 85 mass%), 80 mass% or less, and 70 mass% or less. A particularly preferred mixing ratio is 60 mass% or less.

The mixing ratio of the compound represented by Formula (I) based on the total amount of HFP trimers is adjusted to, for example, 10 mass% or more and 90 mass% or less, 10 mass% or more and 85 mass% or less, 10 mass% or more and less than 85 mass%, 20 mass% or more and less than 85 mass%, 30 mass% or more and 90 mass% or less, 30 mass% or more and less than 85 mass%, 35 mass% or more and 85 mass% or less, 35 mass% or more and 60 mass% or less, 40 mass% or more and less than 85 mass%, 40 mass% or more and 80 mass% or less, 50 mass% or more and less than 85 mass%, 50 mass% or more and 60 mass% or less, 55 mass% or more and 80 mass% or less, 60 mass% or more and 75 mass% or less, or 65 mass% or more and 70 mass% or less.

The mixing ratio of the compound represented by Formula (I) based on the total amount of HFP trimers is preferably in the following order: 30 mass% or more and 90 mass% or less, 40 mass% or more and less than 85 mass%, 40 mass% or more and 80 mass% or less, and 45 mass% or more and 70 mass% or less. A particularly preferred mixing ratio is 50 mass% or more and 60 mass% or less.

(c) Amount of dimer and/or trimer

In the etching gas of the present disclosure, one of hexafluoropropene-derived dimer and/or trimer may be used alone or two or more thereof may be used (blended) as a mixture.

In order to reduce lateral etching, achieve etching in which the processed hole shape is well maintained, and prevent or reduce clogging of holes (clogging) in the processed shape when the etching gas of the present disclosure is used for hole etching, the amount of hexafluoropropene-derived dimer and/or trimer in the etching gas of the present disclosure based on the total amount (gas volume) of the etching gas of the present disclosure is preferably 0.1 ppm by volume (ppm volume) to 1,000 ppm by volume (ppm volume), more preferably 0.5 ppm by volume to 500 ppm by volume, even more preferably 0.75 ppm by volume to 100 ppm by volume, and particularly preferably 1 ppm by volume to 50 ppm by volume.

(2-4) Second component

In the etching gas of the present disclosure, at least one component selected from the group consisting of hexafluorocyclopropane, pentafluoropropene, and a hexafluoropropene-derived dimer and/or trimer (the second component) may be used alone or two or more thereof may be used (blended) as a mixture.

The etching gas of the present disclosure, which contains a second component, can reduce lateral etching (or enhance the effect of protecting the base wall) by about 10% to 30% at low cost in hole etching in a semiconductor manufacturing substrate. The etching gas of the present disclosure can reduce the amount of sidewall etching of holes (lateral etching).

(3) Consumption of etching gas

The etching gas of the present disclosure contains (1) hexafluoropropene (HFP) as a first component and (2) at least one component selected from the group consisting of hexafluorocyclopropane, pentafluoropropene, and a hexafluoropropene-derived dimer and/or trimer as a second component.

For successful and efficient etching, the consumption of the etching gas of the present disclosure is preferably 2 ccm to 100 ccm, more preferably 5 ccm to 50 ccm, and even more preferably 8 ccm to 15 ccm.

In the present specification, the gas consumption unit "ccm" stands for cubic centimeter/min (cc/min) and represents the volume (cc, $cm^3$) when the instantaneous flow rate is sustained for one minute under conditions of 25°C and a pressure equivalent to 1 atmosphere pressure.

(4) Other etching gases

The etching gas of the present disclosure may contain (5) another etching gas as needed for successful etching.

The other etching gas preferably includes hydrofluorocarbon compounds (HFC) such as $CH_2F_2$, $CHF_3$, $C_2H_2F_2$, $C_2H_4F_2$, and $C_3H_2F_4$; perfluorocarbon compounds (PFC) such as $CF_4$, $C_2F_6$, $C_3F_8$, $C_4F_8$, $C_4F_6$, and $C_5F_8$; iodides such as $CF_3I$, $C_2F_5I$, and $C_3F_7I$; and $SF_6$. The etching rate can be adjusted using such etching gas.

In the etching gas of the present disclosure, another etching gas may be used alone or two or more thereof may be used (blended) as a mixture.

[2] Etching method

The present disclosure encompasses a method for etching a semiconductor manufacturing substrate using the etching gas of the present disclosure, which is supplied as a plasma-generating gas.

The present disclosure encompasses a method for etching a silicon oxide film ($SiO_2$ film) or a silicon-based material having a silicon nitride film (SiN film) formed thereon using a gas plasma of the etching gas of the present disclosure.

The silicon-based material to be etched is preferably a semiconductor manufacturing substrate.

When hole etching is performed in a silicon oxide film ($SiO_2$ film) or a silicon-based material including a silicon nitride film (SiN film) using a gas plasma generated from the etching gas of the present disclosure, good etching can be achieved in which the processed hole shape is well maintained. The conditions for the etching method (in particular, the dry etching method) are the same as those for the conventional method, except that the etching gas of the present disclosure is used.

(1) Example of etching conditions

The etching conditions may be as follows, for example.

The flow rate is adjusted to 5 ccm to 2,000 ccm, preferably 10 ccm to 1,000 ccm.

The discharge power is adjusted to 200 W to 20,000 W, preferably 400 W to 10,000 W.

The high-frequency power supply is adjusted to 13.56 MHz and 0.22 W.

The bias power is adjusted to 25 W to 15,000 W, preferably 100 W to 10,000 W.

The pressure is adjusted to 30 mTorr or less (3.99 Pa or less), preferably 2 mTorr to 10 mTorr (0.266 Pa to 1.33 Pa).

The pressure refers to the gauge pressure, unless otherwise specified.

The electron density is adjusted to $10^9$ $cm^{-3}$ to $10^{13}$ $cm^{-3}$, preferably $10^{10}$ $cm^{-3}$ to $10^{12}$ $cm^{-3}$.

The electronic temperature is adjusted to 2 eV to 9 eV, preferably 3 eV to 8 eV.

The wafer temperature is adjusted to -40°C to 100°C, preferably -30°C to 50°C.

The chamber wall temperature is adjusted to -30°C to 300°C, preferably 20°C to 200°C.

The discharge power and bias power vary depending on factors such as the chamber size and electrode size. The following describes preferred etching conditions that can be used when etching patterns such as contact holes in silicon oxide films and the like using small-diameter wafer inductively coupled plasma (ICP) etching equipment (with a chamber volume of 3,500 $cm^3$).

The discharge power is adjusted to 200 W to 1,000 W, preferably 300 W to 600 W.

The bias power is adjusted to 50 W to 500 W, preferably 100 W to 300 W.

(2) Inert gas

When etching is performed using the etching gas of the present disclosure, the etching gas of the present disclosure may contain an inert gas as needed for successful etching.

In the etching method of the present disclosure, preferably, a silicon-based material is etched by continuously supplying the etching gas of the present disclosure and an inert gas separately, and generating an etching gas mixture in a chamber.

The inert gas preferably may contain one or more of a noble gas, nitrogen, or the like. The noble gas preferably may contain helium, neon, argon, xenon, krypton, or the like. The use of argon (Ar) is more preferred.

When etching is performed using the etching gas of the present disclosure, one inert gas may be used alone or two or more thereof may be used (blended) as a mixture.

The inert gas can change the electronic temperature and electron density of the plasma, and can control the balance between fluorocarbon radicals and fluorocarbon ions.

When etching is performed using the etching gas of the present disclosure and the etching gas contains an inert gas (Ar or the like), the consumption of inert gas for successful etching is preferably 50 ccm to 500 ccm, more preferably 150 ccm to 400 ccm, and even more preferably 220 ccm to 280 ccm.

When etching is performed using the etching gas of the present disclosure and the etching gas contains an inert

gas (Ar or the like), the consumption of inert gas for successful etching is preferably 5 to 50 times, more preferably 15 to 40 times, and even more preferably 22 to 28 times the flow rate of the etching gas.

(3) Oxidizing gas and/or reducing gas

When etching is performed using the etching gas of the present disclosure, the etching gas of the present disclosure may contain an oxidizing gas and/or a reducing gas as needed for successful etching.
In the etching method of the present disclosure, preferably, a silicon-based material is etched by continuously supplying the etching gas of the present disclosure and an oxidizing gas and/or a reducing gas separately and generating an etching gas mixture in a chamber.
It is more preferred to use $O_2$, $O_3$, NO, $N_2O$, $NO_2$, $SO_2$, COS, CO, or $CO_2$ as the oxidizing gas, and it is even more preferred to use oxygen ($O_2$), whereby a good etching profile can be obtained.
When etching is performed using the etching gas of the present disclosure, one oxidizing gas may be used alone or two or more thereof may be used (blended) as a mixture.
When etching is performed using the etching gas of the present disclosure and the etching gas contains an oxidizing gas ($O_2$ or the like), the consumption of oxidizing gas for successful and efficient etching is preferably 2 ccm to 100 ccm, more preferably 5 ccm to 50 ccm, and even more preferably 8 ccm to 15 ccm.
When etching is performed using the etching gas of the present disclosure and the etching gas contains an oxidizing gas ($O_2$ or the like), the consumption of oxidizing gas for successful and efficient etching is preferably 0.2 to 10 times, more preferably 0.5 to 5 times, and even more preferably 0.8 to 1.5 times the flow rate of the etching gas.
It is preferred to use hydrogen ($H_2$), CO, $CH_4$ or the like as the reducing gas, whereby a good etching profile can be obtained when hole etching is performed particularly in a silicon-based material including a silicon nitride film (SiN film).
When etching is performed using the etching gas of the present disclosure, one reducing gas may be used alone or two or more thereof may be used (blended) as a mixture.
When etching is performed using the etching gas of the present disclosure and the etching gas contains a reducing gas ($H_2$ or the like), the consumption of reducing gas for successful and efficient etching is preferably 0.5 ccm to 20 ccm, more preferably 0.8 ccm to 10 ccm, and even more preferably 1 ccm to 5 ccm.
When etching is performed using the etching gas of the present disclosure and the etching gas contains a reducing gas ($H_2$ or the like), the consumption of reducing gas for successful and efficient etching is preferably 0.05 to 2 times, more preferably 0.08 to 1 time, and even more preferably 0.1 to 0.5 times of the flow rate of the etching gas.
When etching is performed using the etching gas of the present disclosure, one oxidizing gas may be used alone or two or more thereof may be used (blended) as a mixture, and one reducing gas may be used alone or two or more thereof may be used (blended) as a mixture.
In the etching method of the present disclosure, preferably, a silicon-based material is etched by continuously supplying the etching gas of the present disclosure, an inert gas separately, and an oxidizing gas and/or a reducing gas separately and generating an etching gas mixture in a chamber.

[3] Semiconductor production equipment

The present disclosure encompasses semiconductor production equipment including a gas outlet for the etching gas of the present disclosure.

[4] Method for producing semiconductor

The present disclosure encompasses a method for producing a semiconductor, the method including etching a semiconductor manufacturing substrate using the etching gas of the present disclosure.

[5] Use for producing semiconductor

The present disclosure encompasses use of the etching gas of the present disclosure for semiconductor production, which involves etching a semiconductor manufacturing substrate.
The etching gas of the present disclosure contains (1) hexafluoropropene as a first component and (2) at least one component selected from the group consisting of hexafluorocyclopropane, pentafluoropropene, and a hexafluoropropene-derived dimer and/or trimer as a second component. Use of the etching gas of the present disclosure for hole etching can prevent or reduce clogging of holes (clogging) in the processed shape, reduce lateral etching, achieve etching in which the processed shape of the holes is well maintained.
The etching gas of the present disclosure, which contains a second component, can reduce lateral etching (or enhance the effect of protecting the base wall) by about 10% to 30% at low cost in hole etching in a semiconductor

manufacturing substrate. The etching gas of the present disclosure can reduce the amount of sidewall etching of holes (lateral etching).

Examples

The present invention is specifically described below with reference to Examples and Comparative Examples, which do not limit the present invention.

[1] Etching method

After hexafluoropropene (HFP) and an additive gas (a second component) were introduced from a gas inlet connected to an upper electrode, the process gas was excited using a high-frequency power supply (13.56 MHz, 0.22 W) to perform etching.

An etching gas containing HFP and the additive gas, oxygen (an oxidizing gas), Ar (an inert gas), and hydrogen (reducing gas when etching a SiN film) were supplied from separate lines to form an etching gas mixture in a chamber to perform etching.

A silicon oxide film ($SiO_2$ film) and a silicon nitride film (SiN film) formed on a silicon substrate were etched using inductively coupled plasma (ICP) under the following etching conditions: discharge power: 1,000 W; bias power: 300 W; pressure: 10 mTorr; electron density: $8 \times 10^{10}$ $cm^{-3}$ to $2 \times 10^{11}$ $cm^{-3}$; electronic temperature: 5 eV to 7 eV.

[2] Measurement of aspect ratio and lateral etching

A silicon wafer cross section after etching was observed by SEM to measure the aspect ratio and the lateral etching (the amount of sidewall etching).

(1) Aspect ratio

In hole etching in the $SiO_2$ film and the SiN film, the aspect ratio represents the depth (relative value $\alpha$) of a hole relative to the width (1) of the hole, i.e., etching depth/etching width (dimension). A larger aspect ratio (higher aspect ratio) indicates deeper etching (higher aspect ratio etching).

(2) Lateral etching rate

In the Examples, a lower lateral etching rate (relative value) indicates reduced lateral etching, compared to the Comparative Examples (examples without the additive gas).

$$\text{Lateral etching rate } R = a/b*100$$

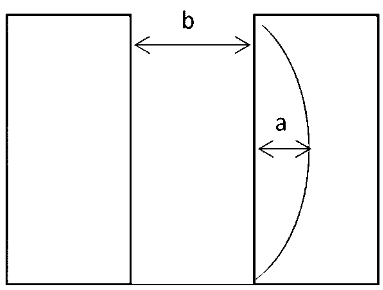

[Table 1]

| Additive gas: Hexafluorocyclopropane (c-$C_3F_6$) | | | | | | | | | |
|---|---|---|---|---|---|---|---|---|---|
| | Film type | Additive gas | Concentration ppm by volume | Flow rate ccm | Oxygen ccm | Ar ccm | Hydrogen ccm | Aspect ratio | Lateral etching rate relative value (relative to Comparative Example) |
| Comparative Example 1-1 | $SiO_2$ | c-$C_3F_6$ | Absent | 10 | 10 | 250 | - | 7 or more | 1 |
| Example 1-1 | $SiO_2$ | c-$C_3F_6$ | 0.1 | 10 | 10 | 250 | - | 7 or more | 0.93 |
| Example 1-2 | $SiO_2$ | c-$C_3F_6$ | 5 | 10 | 10 | 250 | - | 7 or more | 0.90 |
| Example 1-3 | $SiO_2$ | c-$C_3F_6$ | 100 | 10 | 10 | 250 | - | 7 or more | 0.88 |
| Example 1-4 | $SiO_2$ | c-$C_3F_6$ | 200 | 10 | 10 | 250 | - | 7 or more | 0.73 |
| Comparative Example 1-2 | SiN | c-$C_3F_6$ | Absent | 10 | 10 | 250 | 2 | 6 or more | 1 |
| Example 1-5 | SiN | c-$C_3F_6$ | 0.1 | 10 | 10 | 250 | 2 | 7 or more | 0.95 |
| Example 1-6 | SiN | c-$C_3F_6$ | 5 | 10 | 10 | 250 | 2 | 6 or more | 0.93 |
| Example 1-7 | SiN | c-$C_3F_6$ | 100 | 10 | 10 | 250 | 2 | 6 or more | 0.88 |
| Example 1-8 | SiN | c-$C_3F_6$ | 200 | 10 | 10 | 250 | 2 | 6 or more | 0.8 |

[Table 2]

| Additive gas: Pentafluoropropene ($C_3HF_5$) | | | | | | | | | |
|---|---|---|---|---|---|---|---|---|---|
| | Film type | Additive gas | Concentration ppm by volume | Flow rate ccm | Oxygen ccm | Ar ccm | Hydrogen ccm | Aspect ratio | Lateral etching rate relative value (relative to Comparative Example) |
| Comparative Example 2-1 | $SiO_2$ | $C_3HF_5$ | Absent | 10 | 10 | 250 | - | 7 or more | 1 |
| Example 2-1 | $SiO_2$ | $C_3HF_5$ | 22 | 10 | 10 | 250 | - | 7 or more | 0.95 |
| Example 2-2 | $SiO_2$ | $C_3HF_5$ | 50 | 10 | 10 | 250 | - | 7 or more | 0.94 |
| Example 2-3 | $SiO_2$ | $C_3HF_5$ | 100 | 10 | 10 | 250 | - | 7 or more | 0.85 |
| Example 2-4 | $SiO_2$ | $C_3HF_5$ | 300 | 10 | 10 | 250 | - | 7 or more | 0.83 |
| Comparative Example 2-2 | SiN | $C_3HF_5$ | Absent | 10 | 10 | 250 | 2 | 6 or more | 1 |

(continued)

| Additive gas: Pentafluoropropene ($C_3HF_5$) | | | | | | | | | |
|---|---|---|---|---|---|---|---|---|---|
| | Film type | Additive gas | Concentration ppm by volume | Flow rate ccm | Oxygen ccm | Ar ccm | Hydrogen ccm | Aspect ratio | Lateral etching rate relative value (relative to Comparative Example) |
| Example 2-5 | SiN | $C_3HF_5$ | 21 | 10 | 10 | 250 | 2 | 6 or more | 0.95 |
| Example 2-6 | SiN | $C_3HF_5$ | 50 | 10 | 10 | 250 | 2 | 6 or more | 0.92 |
| Example 2-7 | SiN | $C_3HF_5$ | 100 | 10 | 10 | 250 | 2 | 6 or more | 0.88 |
| Example 2-8 | SiN | $C_3HF_5$ | 300 | 10 | 10 | 250 | 2 | 6 or more | 0.81 |

[Table 3]

| Additive gas: Dimer and/or trimer (total) | | | | | | | | | |
|---|---|---|---|---|---|---|---|---|---|
| | Film type | Additive gas | Concentration ppm by volume | Flow rate ccm | Oxygen ccm | Ar ccm | Hydrogen ccm | Aspect ratio | Lateral etching rate relative value (relative to Comparative Example) |
| Comparative Example 3-1 | $SiO_2$ | Dimer, trimer | Absent | 10 | 10 | 250 | - | 7 or more | 1 |
| Example 3-1 (a) | $SiO_2$ | Dimer + trimer | 10 | 10 | 10 | 250 | - | 6 or more | 0.98 |
| Example 3-1 (b) | $SiO_2$ | Dimer | 2 | 10 | 10 | 250 | - | 6 or more | 0.98 |
| Example 3-1 (c) | $SiO_2$ | Trimer | 4 | 10 | 10 | 250 | - | 6 or more | 0.98 |
| Example 3-2 (a) | $SiO_2$ | Dimer + trimer | 15 | 10 | 10 | 250 | - | 6 or more | 0.96 |
| Example 3-2 (b) | $SiO_2$ | Dimer | 4 | 10 | 10 | 250 | - | 6 or more | 0.96 |
| Example 3-2 (c) | $SiO_2$ | Trimer | 8 | 10 | 10 | 250 | - | 6 or more | 0.96 |
| Example 3-3 (a) | $SiO_2$ | Dimer + trimer | 20 | 10 | 10 | 250 | - | 6 or more | 0.95 |
| Example 3-3(b) | $SiO_2$ | Dimer | 7 | 10 | 10 | 250 | - | 6 or more | 0.95 |
| Example 3-3(c) | $SiO_2$ | Trimer | 13 | 10 | 10 | 250 | - | 6 or more | 0.95 |

(continued)

| | Film type | Additive gas | Concentration ppm by volume | Flow rate ccm | Oxygen ccm | Ar ccm | Hydrogen ccm | Aspect ratio | Lateral etching rate relative value (relative to Comparative Example) |
|---|---|---|---|---|---|---|---|---|---|
| Example 3-4(a) | $SiO_2$ | Dimer + trimer | 40 | 10 | 10 | 250 | - | 6 or more | 0.94 |
| Example 3-4(b) | $SiO_2$ | Dimer | 18 | 10 | 10 | 250 | - | 6 or more | 0.94 |
| Example 3-4 (c) | $SiO_2$ | Trimer | 15 | 10 | 10 | 250 | - | 6 or more | 0.94 |
| Example 3-5 (a) | $SiO_2$ | Dimer + trimer | 50 | 10 | 10 | 250 | - | 6 or more | 0.93 |
| Example 3-5 (b) | $SiO_2$ | Dimer | 16 | 10 | 10 | 250 | - | 6 or more | 0.93 |
| Example 3-5 (c) | $SiO_2$ | Trimer | 34 | 10 | 10 | 250 | - | 6 or more | 0.93 |
| Example 3-6 (a) | $SiO_2$ | Dimer + trimer | 100 | 10 | 10 | 250 | - | 6 or more | 0.91 |
| Example 3-6(b) | $SiO_2$ | Dimer | 30 | 10 | 10 | 250 | - | 6 or more | 0.92 |
| Example 3-6 (c) | $SiO_2$ | Trimer | 60 | 10 | 10 | 250 | - | 6 or more | 0.91 |
| Example 3-7 (a) | $SiO_2$ | ' Dimer + trimer | 300 | 10 | 10 | 250 | - | 6 or more | 0.89 |
| Example 3-7(b) | $SiO_2$ | Dimer | 100 | 10 | 10 | 250 | - | 6 or more | 0.88 |
| Example 3-7 (c) | $SiO_2$ | Trimer | 200 | 10 | 10 | 250 | - | 6 or more | 0.89 |

[Table 4]

| Additive gas: Dimer and/or trimer (total) | | | | | | | | | |
|---|---|---|---|---|---|---|---|---|---|
| | Film type | Additive gas | Concentration ppm by volume | Flow rate ccm | Oxygen ccm | Ar ccm | Hydrogen ccm | Aspect ratio | Lateral etching rate relative value (relative to Comparative Example) |
| Comparative Example 3-2 | SiN | Dimer, trimer | Absent | 10 | 10 | 250 | 2 | 6 or more | 1 |
| Example 3-8 (a) | SiN | Dimer + trimer | 10 | 10 | 10 | 250 | 2 | 6 or more | 0.94 |
| Example 3-8 (b) | SiN | Dimer | 2 | 10 | 10 | 250 | 2 | 6 or more | 0.94 |
| Example 3-8 (c) | SiN | Trimer | 4 | 10 | 10 | 250 | 2 | 6 or more | 0.94 |

(continued)

| Additive gas: Dimer and/or trimer (total) | | | | | | | | | |
|---|---|---|---|---|---|---|---|---|---|
| | Film type | Additive gas | Concentration ppm by volume | Flow rate ccm | Oxygen ccm | Ar ccm | Hydrogen ccm | Aspect ratio | Lateral etching rate relative value (relative to Comparative Example) |
| Example 3-9 (a) | SiN | Dimer + trimer | 15 | 10 | 10 | 250 | 2 | 6 or more | 0.94 |
| Example 3-9 (b) | SiN | Dimer | 4 | 10 | 10 | 250 | 2 | 6 or more | 0.94 |
| Example 3-9(c) | SiN | trimer | 8 | 10 | 10 | 250 | 2 | 6 or more | 0.94 |
| Example 3-10(a) | SiN | Dimer + trimer | 20 | 10 | 10 | 250 | 2 | 6 or more | 0.94 |
| Example 3-10 (b) | SiN | Dimer | 7 | 10 | 10 | 250 | 2 | 6 or more | 0.94 |
| Example 3-10 (c) | SiN | Trimer | 13 | 10 | 10 | 250 | 2 | 6 or more | 0.94 |
| Example 3-11 (a) | SiN | Dimer + trimer | 40 | 10 | 10 | 250 | 2 | 6 or more | 0.94 |
| Example 3-11 (b) | SiN | Dimer | 18 | 10 | 10 | 250 | 2 | 6 or more | 0.94 |
| Example 3-11 (c) | SiN | Trimer | 15 | 10 | 10 | 250 | 2 | 6 or more | 0.94 |
| Example 3-12(a) | SiN | Dimer + trimer | 50 | 10 | 10 | 250 | 2 | 6 or more | 0.95 |
| Example 3-12 (b) | SiN | Dimer | 16 | 10 | 10 | 250 | 2 | 6 or more | 0.94 |
| Example 3-12 (c) | SiN | Trimer | 34 | 10 | 10 | 250 | 2 | 6 or more | 0.95 |
| Example 3-13 (a) | SiN | Dimer + trimer | 100 | 10 | 10 | 250 | 2 | 6 or more | 0.92 |
| Example 3-13 (b) | SiN | Dimer | 30 | 10 | 10 | 250 | 2 | 6 or more | 0.91 |
| Example 3-13 (c) | SiN | Trimer | 60 | 10 | 10 | 250 | 2 | 6 or more | 0.92 |
| Example 3-14 (a) | SiN | Dimer + trimer | 300 | 10 | 10 | 250 | 2 | 6 or more | 0.89 |
| Example 3-14 (b) | SiN | Dimer | 100 | 10 | 10 | 250 | 2 | 6 or more | 0.90 |
| Example 3-14 (c) | SiN | Trimer | 200 | 10 | 10 | 250 | 2 | 6 or more | 0.89 |

The use of the etching gases of the Examples for hole etching in the $SiO_2$ films and the silicon-based materials each including a SiN film reduced lateral etching (the lateral etching rate was low as compared to the Comparative Examples), and achieved etching in which the processed hole shape was well maintained.

The etching gases of the Examples reduced lateral etching by about 10% to 30% in hole etching and successfully

reduced lateral etching.

[3] Industrial Applicability

The etching gas of the present disclosure contains (1) hexafluoropropene as a first component and (2) at least one component selected from the group consisting of hexafluorocyclopropane, pentafluoropropene, and a hexafluoropropene-derived dimer and/or trimer as a second component. Use of the etching gas of the present disclosure for hole etching in a silicon oxide film ($SiO_2$ film) or a silicon-based material including a silicon nitride film (SiN film) can reduce lateral etching and achieve etching in which the processed hole shape is well maintained.

The etching gas of the present disclosure, which contains a second component, can reduce lateral etching (or enhance the effect of protecting the base wall) by about 10% to 30% at low cost in hole etching in a semiconductor manufacturing substrate. The etching gas of the present disclosure can reduce the amount of sidewall etching of holes (lateral etching).

## Claims

**1.** An etching gas comprising:

(1) hexafluoropropene; and
(2) at least one component selected from the group consisting of hexafluorocyclopropane, pentafluoropropene, and a hexafluoropropene-derived dimer and/or trimer.

**2.** The etching gas according to claim 1,
wherein, based on the total amount of the etching gas,

the hexafluoropropene (1) is present at 95 vol% to 99.99999 vol%, and
the at least one component selected from the group consisting of hexafluorocyclopropane, pentafluoropropene, and a hexafluoropropene-derived dimer and/or trimer (2) is present at 1 ppm by volume to 1,000 ppm by volume.

**3.** An etching method comprising etching a silicon oxide film or a silicon-based material having a silicon nitride film formed thereon using a gas plasma of the etching gas according to claim 1.

**4.** The etching method according to claim 3,
wherein the silicon-based material is etched by continuously supplying the etching gas and (3) an inert gas separately and generating an etching gas mixture in a chamber.

**5.** The etching method according to claim 3,
wherein the silicon-based material is etched by continuously supplying the etching gas and (4) an oxidizing gas and/or a reducing gas separately and generating an etching gas mixture in a chamber.

**6.** The etching method according to claim 3,
wherein the silicon-based material is etched by continuously supplying the etching gas, (3) an inert gas, and (4) an oxidizing gas and/or a reducing gas separately and generating an etching gas mixture in a chamber.

**7.** The etching method according to any one of claims 3 to 6,
wherein the silicon-based material is a semiconductor manufacturing substrate.

## INTERNATIONAL SEARCH REPORT

International application No.
**PCT/JP2025/018801**

**A. CLASSIFICATION OF SUBJECT MATTER**

***H01L 21/3065***(2006.01)i
FI: H01L21/302 105A; H01L21/302 101C

According to International Patent Classification (IPC) or to both national classification and IPC

**B. FIELDS SEARCHED**

Minimum documentation searched (classification system followed by classification symbols)

H01L21/3065

Documentation searched other than minimum documentation to the extent that such documents are included in the fields searched

Published examined utility model applications of Japan 1922-1996
Published unexamined utility model applications of Japan 1971-2025
Registered utility model specifications of Japan 1996-2025
Published registered utility model applications of Japan 1994-2025

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | US 2020/0312680 A1 (APPLIED MATERIALS INC.) 01 October 2020 (2020-10-01) claims, paragraphs [0002], [0017], [0024], [0026], [0029] | 1-7 |
| X | JP 2024-517288 A (LAM RESEARCH CORPORATION) 19 April 2024 (2024-04-19) paragraphs [0152]-[0153], [0158], [0174], [0194]-[0195], [0264]-[0266] | 1-7 |
| X | JP 2018-141146 A (CENTRAL GLASS CO., LTD.) 13 September 2018 (2018-09-13) paragraphs [0002]-[0003], [0025], [0057] | 1-7 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **18 June 2025** | **08 July 2025** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2025/018801**

| Patent document cited in search report | Publication date (day/month/year) | Patent family member(s) | Publication date (day/month/year) |
|---|---|---|---|
| US 2020/0312680 A1 | 01 October 2020 | (Family: none) | |
| JP 2024-517288 A | 19 April 2024 | WO 2022/241042 A1<br>paragraphs [0152]-[0153], [0158], [0174], [0194]-[0195], [0264]-[0266]<br>CN 115702474 A<br>TW 202309328 A<br>KR 10-2024-0008230 A | |
| JP 2018-141146 A | 13 September 2018 | US 2019/0345385 A1<br>paragraphs [0002]-[0003], [0033], [0065]<br>WO 2018/159368 A1<br>TW 201835383 A<br>KR 10-2019-0124258 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*


### Patent documents cited in the description

- WO 0221586 A1
- JP H06234672 A

### Non-patent literature cited in the description

- *Chem Bar*, 1973, vol. 106, 2950-2959